# EUROPEAN PATENT APPLICATION

(11) **EP 2 671 966 A2**
(43) Date of publication of application: **11.12.2013**
(21) Application number: 13171134.3
(22) Date of filing: 07.06.2013
(51) Int. Cl.: C23C 14/18, C23C 14/02, C23C 16/24, C23C 16/48, H01L 29/66, H01L 29/49, C23C 16/02, H01L 29/786, C30B 29/06, H01L 21/20

(54) **Method of forming thin film poly silicon layer**

(30) Priority: 08.06.2012 TW 101120669; 18.07.2012 TW 101125823
(71) Applicant: Wintek Corporation, 42760 Taichung City (TW)
(72) Inventor: Huang, Hieng-Hsiung, 300 Hsinchu City (TW); Wang, Wen-Chun, 407 Taichung City (TW); Chang, Heng-Yi, 105 Taipei City (TW); Liu, Chin-Chang, 427 Taichung City (TW)
(74) Representative: Becker Kurig Straus

(57) **Abstract**

A method of forming a thin film poly silicon layer (120, 220, 320, 420, 520, 620) includes following steps. Firstly, a substrate (110, 310, 510) is provided. The substrate (110, 310, 510) has a first surface (110A, 310A, 510A). A heating treatment is then performed. A thin film poly silicon layer (120, 220, 320, 420, 520, 620) is then directly formed on the first surface (110A, 310A, 510A) of the substrate (110, 310, 510) by a silicon thin film deposition process.

## Description

### Field of the Invention

This invention generally relates to a method of forming a thin film poly silicon layer according to the pre-characterizing clauses of claim 1.

### Background of the Invention

Flat display device applications are being developed rapidly. Flat display devices are being installed in electronics, such as televisions, cell phones, mobiles, and refrigerators. A thin film transistor (TFT) is a kind of semiconductor device commonly used in the flat display device, such as a liquid crystal display (LCD), an organic light emitting diode (OLED) display, and an electronic paper (E-paper).

The thin film transistors in current display industries mainly include amorphous silicon thin film transistors (a-Si TFTs) and poly silicon thin film transistors. The amorphous silicon thin film transistor is currently the mainstream thin film transistor applied in the display industry because of its mature process techniques and high yield. However, the amorphous silicon thin film transistor may not be good enough to satisfy requirements of high performance display devices in the foreseeable future, because the electrical mobility of the amorphous silicon thin film transistor, which is mainly determined by material properties of amorphous silicon, cannot be effectively improved by process tuning or design modification. The electrical mobility of the poly silicon thin film transistor is much better because of material properties of poly silicon. In a conventional method of forming a thin film poly silicon layer, an amorphous silicon layer is formed and a thin film poly silicon layer may be obtained after crystallizing the amorphous silicon layer by high temperature or high energy treatments such as laser annealing. However, the crystallization process after the film deposition has several disadvantages such as longer process time, higher cost, and lower manufacturing efficiency. In addition, the uniformity of the crystallization process on a large size substrate is still problematic, and the conventional method of forming the thin film poly silicon layer is accordingly limited to specific products and applications.

### Summary of the Invention

The present invention aims at providing a method of forming a thin film poly silicon layer so as to directly form the thin film poly silicon layer on a substrate by performing a silicon thin film deposition process on the substrate when the substrate is heated to a temperature for forming the thin film poly silicon layer.

This is achieved by a method of forming a thin film poly silicon layer according to the pre-characterizing clauses of claim 1. The dependent claims pertain to corresponding further developments and improvements.

As will be seen more clearly from the detailed description following below, the claimed method of forming a thin film poly silicon layer includes the following steps. Firstly, a substrate is provided. The substrate has a first surface. A heating treatment is then performed. A silicon thin film deposition process is then performed for directly forming a thin film poly silicon layer on the first surface of the substrate.

These and other objectives of the present invention will no doubt become clear to those of ordinary skill in the art after reading the following detailed description of the preferred embodiment that is illustrated in the various figures and drawings.

### Brief Description of the Drawings

The invention is further illustrated by way of example, taking reference to the accompanying drawings. Thereof
FIG. 1 is a flow chart of a method of forming a thin film poly silicon layer according to a first preferred embodiment of the present invention,
FIG. 2 is a schematic diagram illustrating the method of forming the thin film poly silicon layer according to the first preferred embodiment of the present invention,
FIG. 3 is a schematic diagram illustrating a method of forming a thin film poly silicon layer according to a second preferred embodiment of the present invention,
FIG. 4 is a schematic diagram illustrating a method of forming a thin film poly silicon layer according to a third preferred embodiment of the present invention,
FIG. 5 is a schematic diagram illustrating a method of forming a thin film poly silicon layer according to a fourth preferred embodiment of the present invention,
FIG. 6 is a schematic diagram illustrating a method of forming a thin film poly silicon layer according to a fifth preferred embodiment of the present invention,
FIG. 7 is a schematic diagram illustrating a method of forming a thin film poly silicon layer according to a sixth preferred embodiment of the present invention,
FIG. 8 is a flow chart of a method of forming a thin film poly silicon layer according to a seventh preferred embodiment of the present invention,
FIG. 9 is a schematic diagram illustrating the method of forming the thin film poly silicon layer according to the seventh preferred embodiment of the present invention,
FIG. 10 is a flow chart of a method of forming a thin film poly silicon layer according to an eighth preferred embodiment of the present invention,
FIG. 11 is a schematic diagram illustrating the method of forming the thin film poly silicon layer according to the eighth preferred embodiment of the present invention, and
FIG. 12 is a schematic diagram illustrating a method of forming a thin film poly silicon layer according to a ninth preferred embodiment of the present invention.

### Detailed Description

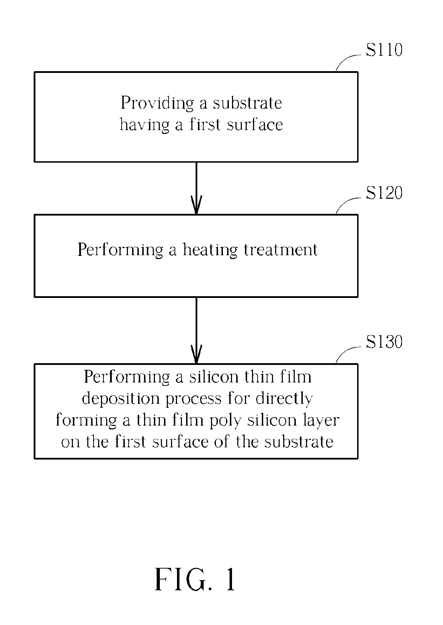

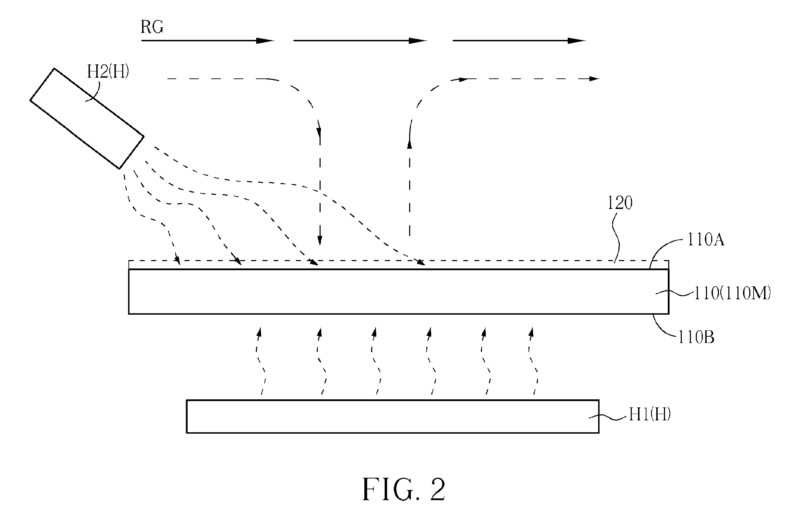

FIG. 1 is a flow chart of a method of forming a thin film poly silicon layer according to a first preferred embodiment of the present invention, and FIG. 2 is a schematic diagram illustrating the method of this embodiment. Please note that the figures are only for illustration and the figures may not be to scale. The scale may be further modified according to different design considerations. The first preferred embodiment of the present invention provides a method of forming a thin film poly silicon layer. The method of forming the thin film poly silicon layer includes the following steps. Firstly, in step S110, a substrate 110 is provided. The substrate 110 has a first surface 110A and a second surface 110B. In addition, the substrate 110 in this embodiment may preferably include a substrate basis 110M. The substrate basis 110M may preferably include a glass substrate basis, a ceramic substrate basis, and/or other substrate bases made of appropriate materials. Subsequently, in step S120, a heating treatment is performed. The heating treatment in this embodiment includes heating the substrate 110 to a temperature higher than 450 degrees Celsius by a heating source H. Preferably, the heating treatment is used to heat the substrate 110 to a temperature higher than 500 degrees Celsius by the heating source H.

The heating source H of this embodiment may preferably include a main heating source H1 and an auxiliary heating source H2. The heating treatment mentioned above may preferably include heating the substrate 110 to a first temperature by the main heating source H1, and heating the first surface 110A of the substrate 110 to a second temperature by the auxiliary heating source H2, but is not limited thereto. The second temperature is preferably higher than the first temperature. For example, the first temperature is preferably higher than 200 degrees Celsius. The second temperature is higher than 450 degrees Celsius, and the second temperature is preferably higher than 500 degrees Celsius.

Subsequently, in step S130, a silicon thin film deposition process is then performed for directly forming a thin film poly silicon layer 120 on the first surface 110A of the substrate 110. Because the first surface 110A of the substrate 110 is heated to a temperature which is high enough for directly forming a thin film poly silicon layer, the thin film poly silicon layer 120 may be directly formed on the first surface 110A accordingly.

As shown in FIG. 2, the silicon thin film deposition process of this embodiment is preferably a chemical vapor deposition (CVD) process, such as a plasma enhanced chemical vapor deposition (PECVD) process, a metal-organic chemical vapor deposition (MOCVD) process, or a low pressure chemical vapor deposition (LPCVD) process, but is not limited thereto. In the silicon thin film deposition process of this embodiment, a reactive gaseous material RG is used to provide a source of silicon, and a thin film silicon layer may be formed on the first surface 110A of the substrate 110. For example, in the silicon thin film deposition process of this embodiment, the reactive gaseous material RG preferably includes silane (SiH₄) and/or dichlorosilane (SiH₂Cl₂), which may be dissociated for forming the thin film silicon layer on the substrate 110. Because the first surface 110A of the substrate 110 is already heated to the temperature, which is high enough for directly forming a thin film poly silicon layer by the auxiliary heating source H2, the thin film poly silicon layer 120 may be directly formed on the first surface 110A of the substrate 110. Other crystallization processes such as a laser annealing process after the silicon thin film deposition process will not be required in this embodiment. Therefore, the method of forming the thin film poly silicon layer in this embodiment has advantages such as reduced process time, lower cost, and higher manufacturing efficiency. Additionally, the uniformity of the thin film poly silicon layer formed by the method of this embodiment is improved because the thin film poly silicon layer 120 is directly formed by the silicon thin film deposition process. The method of forming the thin film poly silicon layer in this embodiment is thus suitable for large area and size substrates.

In addition to heating the first surface 110A of the substrate 110 to the second temperature before the silicon thin film deposition process in the method of forming the thin film poly silicon layer of this embodiment, the auxiliary heating source H2 may also be selectively employed to continuously heat the first surface 110A and the deposited thin film silicon layer in an initial stage or other periods of the silicon thin film deposition process so as to further improve the crystallization quality of the thin film poly silicon layer 120. In addition, the auxiliary heating source H2 in this embodiment may preferably include a high energy heating source such as a light heating source, an ion beam heating source, an electrode beam heating source and/or a filament heating source, and the main heating source H1 in this embodiment may preferably include a susceptor heating source, a radio frequency (RF) heating source and/or a infrared (IR) heating source. Other appropriate heating sources may also be selectively employed as the main heating source H1 and the auxiliary heating source H2 according to different heating considerations. In this embodiment, the first surface 110A of the substrate 110 is mainly heated to the second temperature for forming the thin film poly silicon layer 120. Other parts of the substrate 110 are not required to be heated to the second temperature and thus the heat resistant properties of the substrate 110 may not be of consequence to the invention according to this embodiment.

The following description will describe the different embodiments of the method of forming the thin film poly silicon layer in the present invention. To simplify the description, identical components in each of the following embodiments are marked with identical symbols. To make it easier to understand the differences between the embodiments, the following description will detail the dissimilarities among different embodiments and the identical features will not be redundantly described.

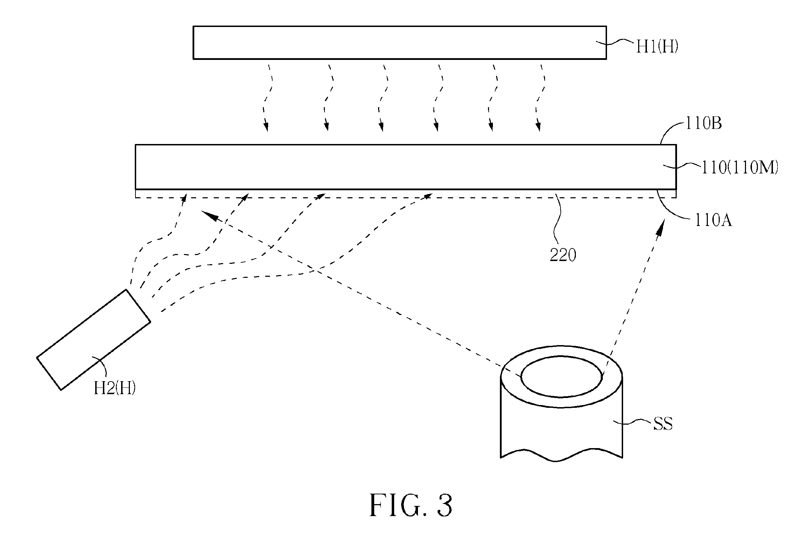

FIG. 3 is a schematic diagram illustrating a method of forming a thin film poly silicon layer according to a second preferred embodiment of the present invention. As shown in FIG. 1 and FIG. 3, the difference between the method of forming the thin film poly silicon layer in this embodiment and the method of the first preferred embodiment is that the silicon thin film deposition process of this embodiment is preferably a physical vapor deposition (PVD) process, and a silicon source SS such as a silicon target may be employed for sputtering a silicon layer on the first surface 110A of the substrate 110. Because the first surface 110A of the substrate 110 is already heated to the second temperature, which is high enough for directly forming a thin film poly silicon layer, by the auxiliary heating source H2, a thin film poly silicon layer 220 may be directly formed on the first surface 110A of the substrate 110. Other crystallization processes after the silicon thin film deposition process are not required in this embodiment. Apart from the type of the silicon thin film deposition process in this embodiment, the other components, allocations, material properties, and the heating treatment in this embodiment are similar to those of the method of forming the thin film poly silicon layer in the first preferred embodiment detailed above and will not be described here again. It is worth noting that, apart from heating the first surface 110A of the substrate 110 to the second temperature by the auxiliary heating source H2 before the silicon thin film deposition process in the method of forming the thin film poly silicon layer of this embodiment, the auxiliary heating source H2 may also be selectively employed to continuously heat the first surface 110A and the deposited thin film silicon layer in an initial stage or other periods of the silicon thin film deposition process so as to further improve the crystallization quality of the thin film poly silicon layer 220.

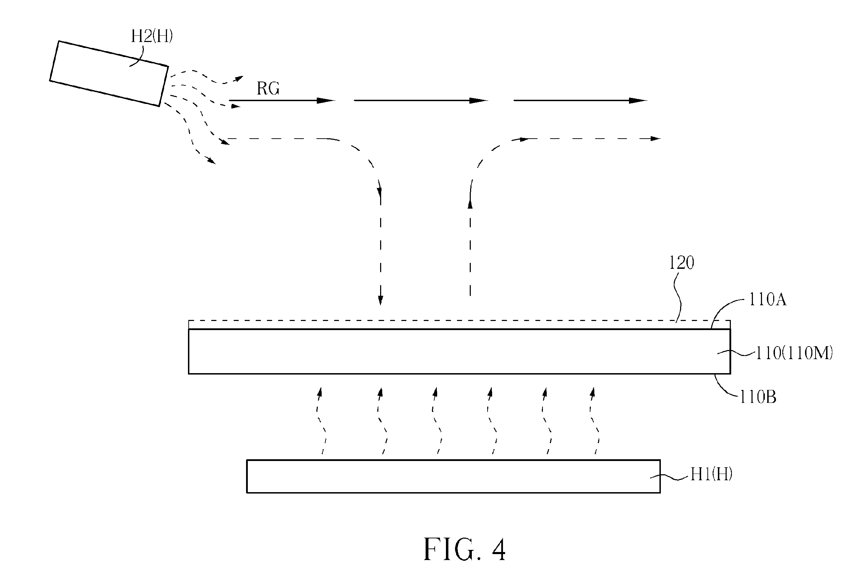

FIG. 4 is a schematic diagram illustrating a method of forming a thin film poly silicon layer according to a third preferred embodiment of the present invention. As shown in FIG. 4, in the silicon thin film deposition process of this embodiment, a reactive gaseous material RG is preferably employed for forming the thin film poly silicon layer 120 on the first surface 110A of the substrate. The reactive gaseous material RG preferably includes silane and/or dichlorosilane, but is not limited thereto. The difference between the method of forming the thin film poly silicon layer in this embodiment and the method of the first preferred embodiment is that the heating treatment in this embodiment preferably includes heating the substrate 110 to a first temperature by the main heating source H1 and heating the reactive gaseous material RG to a second temperature by the auxiliary heating source H2. The second temperature is preferably higher than the first temperature. For instance, the first temperature is preferably higher than 200 degrees Celsius, the second temperature is higher than 450 degrees Celsius, and the second temperature is preferably higher than 500 degrees Celsius. Because the reactive gaseous material RG is already heated to the second temperature, which is high enough for directly forming a thin film poly silicon layer, by the auxiliary heating source H2, the thin film poly silicon layer 120 may be directly formed on the first surface 110A of the substrate 110. Additionally, the auxiliary heating source H2 in this embodiment may preferably include a high energy heating source such as a light heating source, an ion beam heating source, an electrode beam heating source, and/or a filament heating source. Apart from the heating treatment in this embodiment, the other components and material properties in this embodiment are similar to those of the method of forming the thin film poly silicon layer in the first preferred embodiment detailed above and will not be described here again. It is worth noting that, in other preferred embodiments of the present invention, the auxiliary heating source H2 may also be employed to heat both the first surface 110A of the substrate 110 and the reactive gaseous material RG so as to further enhance the crystallization quality of the thin film poly silicon layer 120.

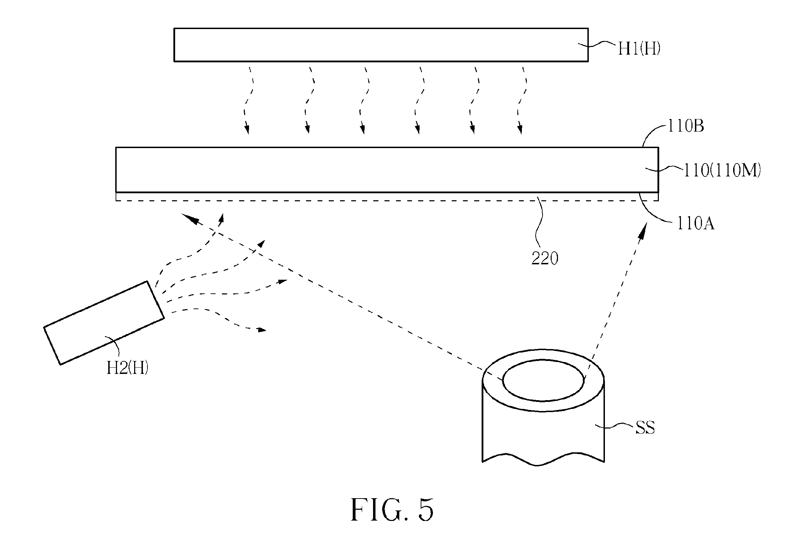

FIG. 5 is a schematic diagram illustrating a method of forming a thin film poly silicon layer according to a fourth preferred embodiment of the present invention. As shown in FIG. 5, the silicon thin film deposition process of this embodiment is preferably a physical vapor deposition process, and the silicon source SS such as a silicon target is employed for sputtering a silicon layer on the first surface 110A of the substrate 110. The difference between the method of forming the thin film poly silicon layer in this embodiment and the method of the second preferred embodiment is that the heating treatment of this embodiment preferably include heating the substrate 110 to a first temperature by the main heating source H1, and heating the silicon source SS to a second temperature by the auxiliary heating source H2 in a stage before forming a silicon layer on the first surface 110A. The second temperature is preferably higher than the first temperature. For instance, the first temperature is preferably higher than 200 degrees Celsius, the second temperature is higher than 450 degrees Celsius, and the second temperature is preferably higher than 500 degrees Celsius. Because the silicon source SS in the stage before forming the silicon layer on the first surface 110A is already heated to the second temperature, which is high enough for directly forming a thin film poly silicon layer, by the auxiliary heating source H2, the thin film poly silicon layer 220 may be directly formed on the first surface 110A of the substrate 110. Additionally, the auxiliary heating source H2 in this embodiment may preferably include a high energy heating source such as a light heating source, an ion beam heating source, an electrode beam heating source, and/or a filament heating source. Apart from the heating treatment in this embodiment, the other components and material properties in this embodiment are similar to those of the method of forming the thin film poly silicon layer in the second preferred embodiment detailed above and will not be described here again. It is worth noting that, in other preferred embodiments of the present invention, the auxiliary heating source H2 may also be employed to heat both the first surface 110A of the substrate 110 and the silicon source SS in the stage before forming the silicon layer on the first surface 110Ato the second temperature so as to further enhance the crystallization quality of the thin film poly silicon layer 220.

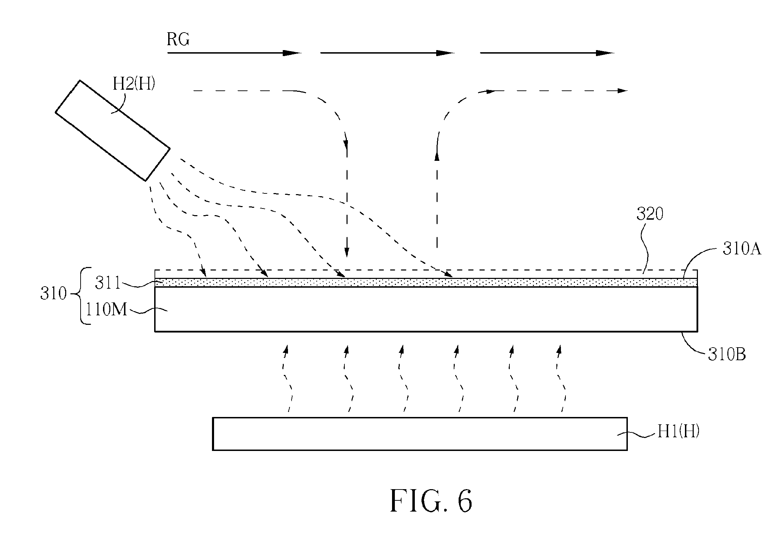

FIG. 6 is a schematic diagram illustrating a method of forming a thin film poly silicon layer according to a fifth preferred embodiment of the present invention. As shown in FIG. 6, the difference between the method of forming the thin film poly silicon layer in this embodiment and the method of the first preferred embodiment is that a substrate 310 in this embodiment include the substrate base 110M and a heating auxiliary layer 311. The heating auxiliary layer 311 is disposed on the substrate basis 110M. The substrate 310 has a first surface 310A and a second surface 310B. In other words, a surface of the heating auxiliary layer 311 opposite to the substrate basis 110M may be regarded as the first surface 310A of the substrate 310. The heating auxiliary layer 311 is used to enhance heating efficiency of the heating source H2, and related process conditions may be further improved. In addition, the heating auxiliary layer 311 is made of a material with high endothermal efficiency. The heating auxiliary layer 311 may preferably include graphite, chromium oxide and/or molybdenum, but is not limited thereto. Because of the heating auxiliary layer 311, the first surface 310A of the substrate 310 may be heated more efficiently to the second temperature, which is high enough for directly forming a thin film poly silicon layer, by the auxiliary heating source H2, and a thin film poly silicon layer 320 may be directly formed on the first surface 310A of the substrate 310. Other crystallization processes after the silicon thin film deposition process are not required in this embodiment.

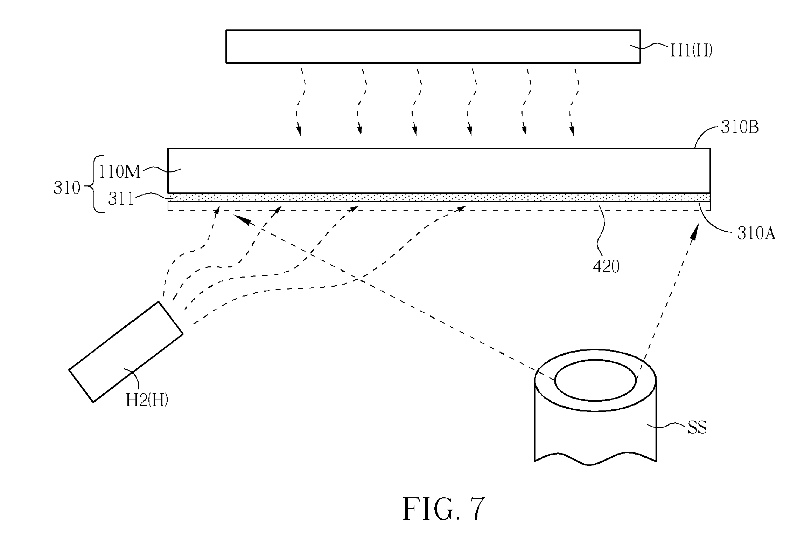

FIG. 7 is a schematic diagram illustrating a method of forming a thin film poly silicon layer according to a sixth preferred embodiment of the present invention. As shown in FIG. 7, the difference between the method of forming the thin film poly silicon layer in this embodiment and the method of the fifth preferred embodiment is that the silicon thin film deposition process of this embodiment is preferably a physical vapor deposition process, and the silicon source SS such as a silicon target is employed for sputtering a silicon layer on the first surface 310A of the substrate 310. In addition, the heating auxiliary layer 311 is used in this embodiment, and the first surface 310A of the substrate 310 may be accordingly heated more efficiently to the second temperature, which is high enough for directly forming a thin film poly silicon layer by the auxiliary heating source H2. The thin film poly silicon layer 320 may be directly formed on the first surface 310A of the substrate 310. Other crystallization processes after the silicon thin film deposition process are not required in this embodiment.

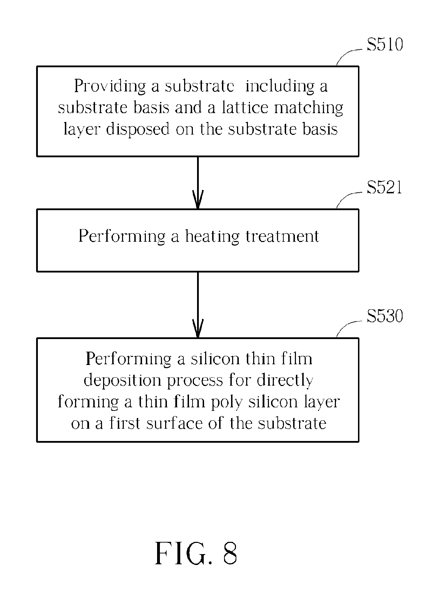

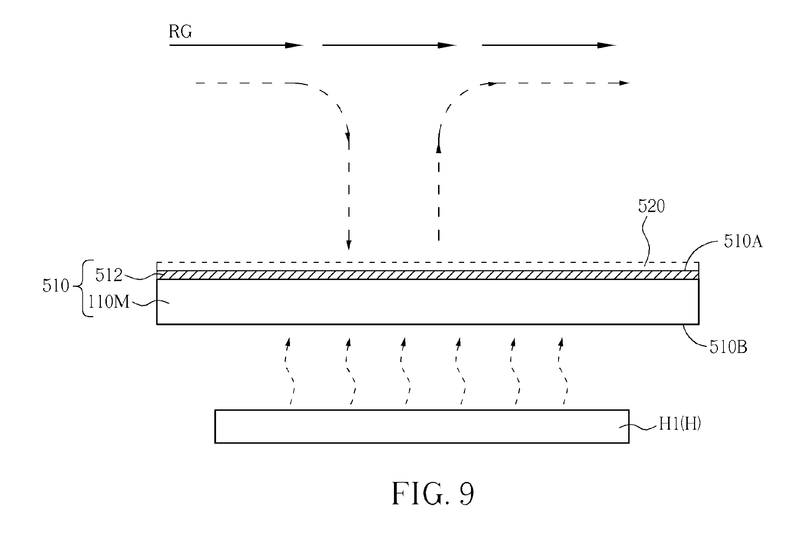

FIG. 8 is a flow chart of a method of forming a thin film poly silicon layer according to a seventh preferred embodiment of the present invention, and FIG. 9 is a schematic diagram illustrating the method of this embodiment. As shown in FIG. 8 and FIG. 9, the seventh preferred embodiment of the present invention provides a method of forming a thin film poly silicon layer. The method of forming the thin film poly silicon layer includes the following steps. Firstly, in step S510, a substrate 510 is provided. The substrate 510 has a first surface 510A and a second surface 510B. In addition, the substrate 510 in this embodiment may preferably include a substrate basis 110M and a lattice matching layer 512. The lattice matching layer 512 is disposed on the substrate basis 110M. In other words, a surface of the lattice matching layer 512 opposite to the substrate basis 110M may be regarded as the first surface 510A of the substrate 510. In addition, the lattice matching layer 512 may preferably include a polymer material having a specific lattice direction and/or a metal oxide material having a specific lattice direction, such as zirconium oxide (ZrO2), cerium oxide (CeO2), praseodymium oxide (PrO2) and/or yttrium oxide (Y2O3), but is not limited thereto. In step S520, a heating treatment is then performed. Subsequently, in step S530, a silicon thin film deposition process is performed for directly forming a thin film poly silicon layer 520 on the first surface 510A of the substrate 510. In this embodiment, the heating treatment may preferably include heating the substrate 510 to a first temperature by the main heating source H1. It is worth noting that the first temperature may be between 150 degrees Celsius and 250 degrees Celsius because of the lattice matching layer 512 in the substrate 510. As shown in FIG. 9, the silicon thin film deposition process of this embodiment is preferably a chemical vapor deposition process, such as a plasma enhanced chemical vapor deposition process, a metal-organic chemical vapor deposition process, or a low pressure chemical vapor deposition process, but is not limited thereto.

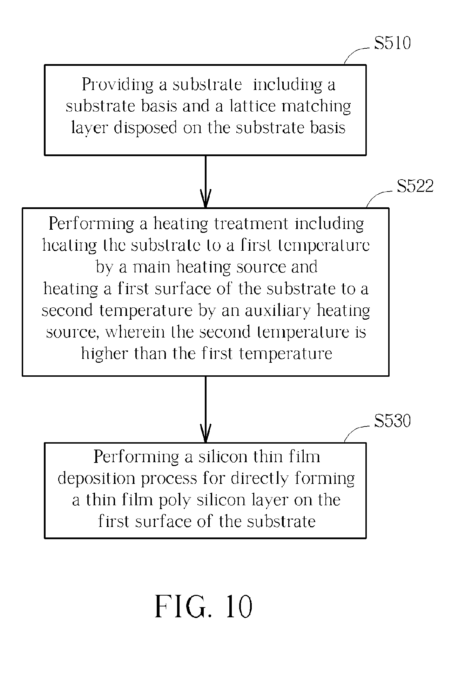

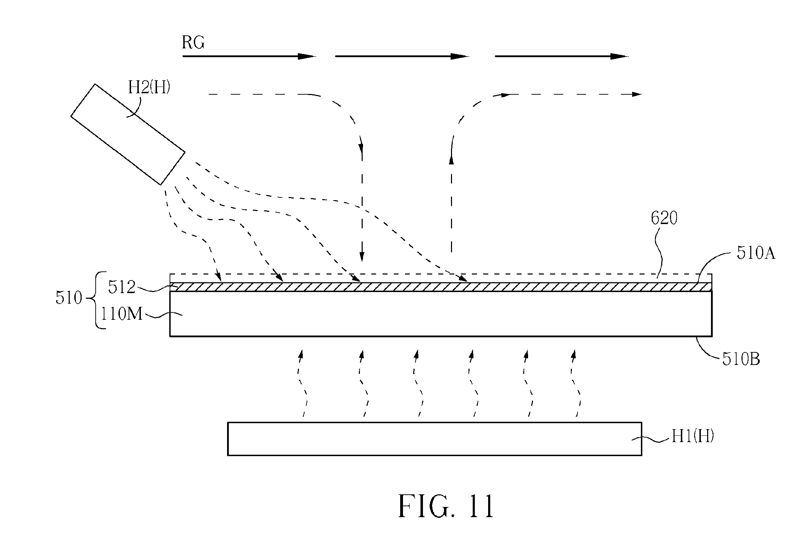

FIG. 10 is a flow chart of a method of forming a thin film poly silicon layer according to an eighth preferred embodiment of the present invention and FIG. 11 is a schematic diagram illustrating the method of this embodiment. As shown in FIG. 10 and FIG. 11, the difference between the method of forming the thin film poly silicon layer in this embodiment and the method of the seventh preferred embodiment is that a heating treatment is performed in step S522 after the step S510 in this embodiment. The heating treatment mentioned above includes heating the substrate 510 to a temperature higher than 250 degrees Celsius by a heating source H. In this embodiment, the heating source H may preferably include a main heating source H1 and an auxiliary heating source H2. The heating treatment may preferably include heating the substrate 510 to a first temperature by the main heating source H1, and heating the first surface 510A of the substrate 510 to a second temperature by the auxiliary heating source H2. The second temperature is preferably higher than the first temperature. For example, the first temperature is preferably higher than 150 degrees Celsius, and the second temperature is preferably higher than 250 degrees Celsius. Subsequently, in step S530, a silicon thin film deposition process is then performed for directly forming a thin film poly silicon layer 620 on the first surface 510A of the substrate 510.

Apart from heating the first surface 510A of the substrate 510 by the auxiliary heating source H2 in this embodiment, the other components, allocations, material properties, and the silicon thin film deposition process in this embodiment are similar to those of the method of forming the thin film poly silicon layer in the seventh preferred embodiment detailed above and will not be described here again. It is worth noting that, apart from heating the first surface 510A of the substrate 510 to the second temperature by the auxiliary heating source H2 before the silicon thin film deposition process in the method of forming the thin film poly silicon layer of this embodiment, the auxiliary heating source H2 may also be selectively employed to continuously heat the first surface 510A, the lattice matching layer 512, and the deposited thin film silicon layer in an initial stage or other periods of the silicon thin film deposition process so as to further improve the crystallization quality of the thin film poly silicon layer 620. In addition, the auxiliary heating source H2 in this embodiment may preferably include a high energy heating source such as a light heating source, an ion beam heating source, an electrode beam heating source and/or a filament heating source, and the main heating source H1 in this embodiment may preferably include a susceptor heating source, a radio frequency heating source and/or a infrared heating source, but the present invention is not limited to this. Other appropriate heating sources may also be selectively employed as the main heating source H1 and the auxiliary heating source H2 for different heating considerations. In this embodiment, the heating temperature of the first surface 510A may be further lowered because of the lattice matching layer 512 in the substrate 510 and thus the heat resistant properties of the substrate 510 may not be of consequence to the invention according to this embodiment.

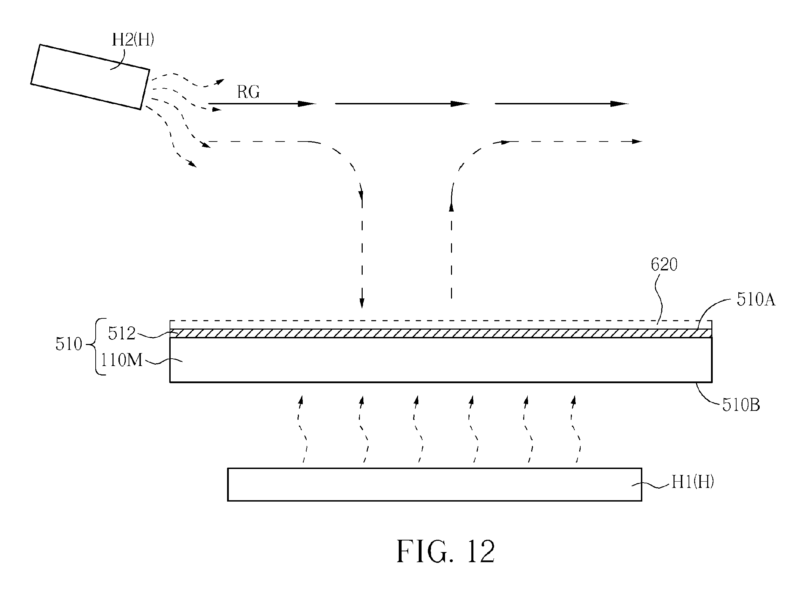

FIG. 12 is a schematic diagram illustrating a method of forming a thin film poly silicon layer according to a ninth preferred embodiment of the present invention. As shown in FIG. 12, in this embodiment, the silicon thin film deposition process of this embodiment may preferably include using a reactive gaseous material RG to form the thin film poly silicon layer 620 on the first surface 510A of the substrate 510. The reactive gaseous material RG may preferably include silane and/or dichlorosilane, but is not limited thereto. The difference between the method of forming the thin film poly silicon layer in this embodiment and the method of the eighth preferred embodiment is that the heating treatment in this embodiment may preferably include heating the substrate 510 to a first temperature by the main heating source H1, and heating the reactive gaseous material RG to a second temperature by the auxiliary heating source H2. The second temperature is preferably higher than the first temperature. For instance, the first temperature is preferably higher than 150 degrees Celsius, and the second temperature is preferably higher than 250 degrees Celsius. Because of the lattice matching layer 512 in the substrate 510, the reactive gaseous material RG may be heated to a relatively low temperature for directly forming the thin film poly silicon layer 620 on the first surface 510A of the substrate 510. Additionally, the auxiliary heating source H2 in this embodiment may preferably include a high energy heating source such as a light heating source, an ion beam heating source, an electrode beam heating source and/or a filament heating source. Apart from the heating treatment in this embodiment, the other components and material properties in this embodiment are similar to those of the method of forming the thin film poly silicon layer in the eighth preferred embodiment detailed above and will not be redundantly described. It is worth noting that, in other preferred embodiments of the present invention, the auxiliary heating source H2 may also be employed to heat both the first surface 510A of the substrate 110 and the reactive gaseous material RG to the second temperature so as to further enhance the crystallization quality of the thin film poly silicon layer 620.

In the method of forming the thin film poly silicon layer according to the present invention, the substrate or the process environment is heated to the temperature which is high enough for directly forming the thin film poly silicon layer, and the silicon thin film deposition process is performed to form the thin film poly silicon layer on the substrate. Advantageously, other crystallization processes after the silicon thin film deposition process are not required accordingly. The method of forming the thin film poly silicon layer in the present invention has advantages such as reduced process time, lower cost, and higher manufacturing efficiency. In addition, the heating auxiliary layer and/or the lattice matching layer may be disposed in the substrate for further enhancing the heating efficiency on the surface of the substrate and further improving the crystallization quality of the thin film poly silicon layer.

## Claims

1. A method of forming a thin film poly silicon layer (120, 220, 320, 420, 520, 620), **characterized by**:
providing a substrate (110, 310, 510), having a first surface (110A, 310A, 510A);
performing a heating treatment; and
performing a silicon thin film deposition process for directly forming a thin film poly silicon layer (120, 220, 320, 420, 520, 620) on the first surface (110A, 310A, 510A) of the substrate (110, 310, 510).

2. The method of claim 1, **characterized in that** the heating treatment comprises heating the substrate (110, 310) to a temperature higher than 500 degrees Celsius by a heating source (H).

3. The method of claim 1, **characterized in that** the silicon thin film deposition process comprises using a reactive gaseous material (RG) to form the thin film poly silicon layer (120, 320, 520, 620) on the first surface (110A, 310A, 510A) of the substrate (110, 310, 510), and the reactive gaseous material (RG) comprises silane (SiH₄) and/or dichlorosilane (SiH₂Cl₂).

4. The method of claim 3, **characterized in that** the heating treatment comprises:
heating the substrate (110, 310, 510) to a first temperature by a main heating source (H1); and
heating the reactive gaseous material (RG) to a second temperature by an auxiliary heating source (H2), wherein the second temperature is higher than the first temperature.

5. The method of claim 4, **characterized in that** the first temperature is higher than 200 degrees Celsius and the second temperature is higher than 500 degrees Celsius.

6. The method of claim 1, **characterized in that** the heating treatment comprises:
heating the substrate (110, 310, 510) to a first temperature by a main heating source (H1); and
heating the first surface (110A, 310A, 510A) of the substrate (110, 310, 510) to a second temperature by an auxiliary heating source (H2), wherein the second temperature is higher than the first temperature.

7. The method of claim 6, **characterized in that** the first temperature is higher than 200 degrees Celsius and the second temperature is higher than 500 degrees Celsius.

8. The method of claim 1, **characterized in that** the substrate (310) comprises a substrate basis (110M) and a heating auxiliary layer (311), and the heating auxiliary layer (311) is disposed on the substrate basis (110M).

9. The method of claim 8, **characterized in that** the heating auxiliary layer (311) comprises graphite, chromium oxide, and/or molybdenum.

10. The method of claim 1, **characterized in that** the substrate (510) comprises a substrate basis (110M) and a lattice matching layer (512), wherein the lattice matching layer (512) is disposed on the substrate basis (110M).

11. The method of claim 10, **characterized in that** the heating treatment comprises heating the substrate (510) to a temperature higher than 250 degrees Celsius by a heating source (H).

12. The method of claim 10, **characterized in that** the lattice matching layer (512) comprises a polymer material having a specific lattice direction and/or a metal oxide material having a specific lattice direction.

13. The method of claim 10, **characterized in that** the silicon thin film deposition process comprises using a reactive gaseous material (RG) to form the thin film poly silicon layer (620) on the first surface (510A) of the substrate (510), wherein the reactive gaseous material (RG) comprises silane (SiH₄) and/or dichlorosilane (SiH₂Cl₂), and the heating treatment comprises:
heating the substrate (510) to a first temperature by a main heating source (H1);and
heating the reactive gaseous material (RG) to a second temperature by an auxiliary heating source (H2), wherein the second temperature is higher than the first temperature, the first temperature is higher than 150 degrees Celsius, and the second temperature is higher than 250 degrees Celsius.

14. The method of claim 10, **characterized in that** the heating treatment comprises:
heating the substrate (510) to a first temperature by a main heating source (H1); and
heating the first surface (510A) of the substrate (510) to a second temperature by an auxiliary heating source (H2), wherein the second temperature is higher than the first temperature, the first temperature is higher than 150 degrees Celsius, and the second temperature is higher than 250 degrees Celsius.

15. The method of claim 10, **characterized in that** the heating treatment comprises heating the substrate (510) to a first temperature by a main heating source (H1), and the first temperature is between 150 degrees Celsius and 250 degrees Celsius.

16. The method of claim 19, **characterized in that** the silicon thin film deposition process comprises a plasma enhanced chemical vapor deposition (PECVD) process, a metal-organic chemical vapor deposition (MOCVD) process, a low pressure chemical vapor deposition (LPCVD) process, or a physical vapor deposition (PVD) process.

17. The method of claim 4, claim 6, claim 13 or claim 14, **characterized in that** the auxiliary heating source (H2) comprises a light heating source, an ion beam heating source, an electrode beam heating source, or a filament heating source.
